# EUROPEAN PATENT SPECIFICATION

(11) **EP 3 756 227 B1**
(45) Date of publication and mention of the grant of the patent: **29.09.2021**
(21) Application number: 19705372.1
(22) Date of filing: 22.02.2019
(51) Int. Cl.: H01L 33/08, H01L 33/20, H01L 33/00, H01L 33/38, H01L 33/32

(54) **SEMICONDUCTOR DEVICE WITH AT LEAST ONE FUNCTIONAL ELEMENT CONTAINING MULTIPLE ACTIVE REGIONS, AND METHOD OF MANUFACTURING THEREOF**
HALBLEITERBAUELEMENT MIT MINDESTENS EINEM FUNKTIONSELEMENT MIT MEHREREN AKTIVEN BEREICHEN UND VERFAHREN ZU SEINER HERSTELLUNG
DISPOSITIF SEMI-CONDUCTEUR AVEC AU MOINS UN ÉLÉMENT FONCTIONNEL CONTENANT DE MULTIPLES RÉGIONS ACTIVES ET SON PROCÉDÉ DE FABRICATION

(30) Priority: 23.02.2018 EP 18158346
(43) Date of publication of application: 30.12.2020
(73) Proprietor: Forschungsverbund Berlin E.V., 12489 Berlin (DE)
(72) Inventor: VAN TREECK, David, 12435 Berlin (DE); FERNANDEZ-GARRIDO, Sergio, 28035 Madrid (ES); LEWIS, Ryan, Hamilton, ON L8L-7P2 (CA)
(74) Representative: v. Bezold & Partner Patentanwälte - PartG mbB
(86) International application number: PCT/EP2019/054447
(87) International publication number: WO 2019/162442

(56) References cited:
- WO-A2-2008/070088
- DE-A1-102012 101 718
- US-A1- 2013 140 521
- US-B1- 8 785 905

## Description

The invention relates to a semiconductor device, in particular for optical, optoelectronic, electronic, and/or (photo-)electrochemical applications, including at least one functional element standing on a substrate and having a thickness in a nanometer to micrometer range, and to a method of manufacturing thereof. Applications of the invention are available e. g. in the fields of light emitters, photocatalytic devices as well as electrochemical and optoelectronic sensors.

For describing the background of the invention, particular reference is made to the following publications:
[1] F. Templier et al. "Journal of SID" 24, 11, 669-675 (2016);
[2] J. W. Matthews et al. in "J. Cryst. Growth" 21, 118-125 (1974);
[3] D. Zubia et al. in "J. Appl. Phys." 85, 6492-6496 (1999);
[4] S. D. Hersee et al. in "J. Mater. Res." 26, 2293-2298 (2011);
[5] N. P. Dasgupta et al. in "Adv. Mater." 26, 2137-84 (2014);
[6] M. D. Mata et al. in "J. Mater. Chem. C" 1, 4300 (2013);
[7] J. K. Hyun et al. in "Annu. Rev. Mater. Res." 43,451-479 (2013);
[8] A. Waag et al. in "Phys. status solidi 8, 2296-2301 (2011);
[9] M. Heigoldt et al. in "J. Mater. Chem. 19, 840 (2009);
[10] R. W. Day et al. in "Nano Lett." 16, 2830-2836 (2016);
[11] S. Gazibegovic et al. in "Nature" 548, 434-438 (2017);
[12] P. Corfdir et al. in "Compd. Semicond. Week" (2017);
[13] US 2011/0309382 A1;
[14] H. Sekiguchi et al. in "Appl. Phys. Lett." 96, 231104 (2010);
[15] S. M. Sadaf et al. in "Nano Lett." 15, 6696-6701 (2015);
[16] Y.-H. Ra et al. in "Nano Lett." 16, 4608-4615 (2016);
[17] R. Wang et al. in "Opt. Express" 22, A1768 (2014);
[18] US 2013/0140521 A1;
[19] US 8 785 905 B1;
[20] WO 2008/070088 A2; and
[21] DE 10 2012 101718 A1.

Conventional semiconductor-based technologies have limitations in terms of multifunctionality and compactness. One example for a multifunctional device is a high-resolution micro displays emitting at multiple colors. These devices are an indispensable component of today's virtual and augmented reality technologies, and their development to smaller and more efficient devices is intensively pursued. However, with conventional fabrication approaches, the brightness as well as the efficiency of these multi-color micro screens drop significantly as pixel size and pitch are decreased to obtain higher display resolution [1]. For multi-color micro displays, as well as for many other applications, new technological approaches are needed for the realization of devices with multiple functionalities and smaller feature size. However, the design diversity of devices based on conventional planar heterostructures is strongly restricted by the planar geometry itself, which also limits the lattice constants of materials which can be combined to form heterostructures [2].

A promising solution to this impediment came with the progress in the field of three-dimensional (3D) nano- and microstructure elements (e.g. nanowires, micro rods, nano/micro fins, etc.) during the last two decades. In contrast to planar structures, their 3D shape provide an enlarged surface and their high aspect ratio allows for the realization of high crystal quality material for many material systems on a wide variety of substrates, independent from the lattice mismatch [3, 4]. Furthermore, with their unique mechanical, electronic, optical, thermal, and magnetic properties, a basis for a new generation of devices has been set [5].

In devices based on 3D nano- and/or microstructure functional elements, a particular device function usually is obtained by an active region provided in or on a core region of the 3D nano- and/or microstructure. Devices with an axial (vertical) configuration as well as devices with a radial (lateral) core-shell configuration for the active region have been demonstrated with different functionalities for numerous applications [5-7]. For instance, in the case of a nanowire geometry, a major advantage of the core-shell configuration, i. e. providing the active region laterally on the side surface perpendicular to the substrate (e. g. a wafer), is that the area of the active region of the device can be drastically increased beyond the footprint of the nanowire on substrate surface [8]. For creating the core-shell configuration, material of the active region usually is deposited e. g. by molecular beam epitaxy (MBE) or metal organic vapor deposition (MOCVD) on the core region, so that the core region is covered by the active region (shell) in all lateral directions (see e. g. structures in [13]). There have also been a few reports where the desired material or a heterostructure was intentionally deposited on only one side surface of a given nanostructure [9-12].

As a disadvantage of the conventionally created 3D nano- and/or microstructure functional elements, the axial as well as the complete or one-sided lateral coverage of the core region allows only limited degrees of freedom for designing the functional element, e. g. by selecting the material or thickness of the active region. In the case where a functional element has only a single functionality, realizing a device with multiple active regions with different individually controllable functions would require complex fabrication processes, e. g. to fabricate different functional elements (each with a different functionality) on a common substrate, or to integrate different elements fabricated separately on a common platform [17]. In the case where multiple functionalities are combined in a single functional element by stacking the active regions on top of each other, the multifunctionality is limited, e.g. to materials, structures or thicknesses which can be grown epitaxial on top of each other, e.g. quantum wells emitting at different wavelength [15]. Furthermore, for these structures it is not feasible to individually control the single active regions, e.g. to individually control the charge carrier injection in the different quantum wells and hence the emission wavelength of the device.

Another approach for creating InGaN/GaN-based nanowires having multiple different emission properties is described in [18] and [19]. In a single deposition run, different In-concentrations are incorporated in the m, r and c crystal planes of the GaN nanowire core, which represent the nanowire's lateral sides (m), upper side (c) and slanted sides (r) therebetween. The different In concentrations result in emissions with different emission wavelengths from each of the crystal planes. Each of the specific emission wavelengths is emitted in all radial directions or the axial direction. The multifunctionality of nanowires obtained with this technique is limited as the different emission properties cannot be tuned independently from each other and the emitting surface areas at the crystal planes have very different sizes and they are vertically separated along the nanowire.

Selective deposition and treatment processes at semiconductor surfaces are known from [20] and [21]. These techniques have been developed for structured surfaces topologies, like e. g. edge emitters, but not for e.g. nanowires, with limited degrees of freedom only. For example, angled deposition on structured surfaces as disclosed in [20] is possible with one single deposition direction only.

The objective of the invention is to provide an improved semiconductor device with at least one functional element on a substrate, being capable of avoiding disadvantages and/or restrictions of conventional semiconductor devices. In particular, the objective is to provide the semiconductor device with an extended range of applications, e. g. for optical, optoelectronic, electronic, and/or (photo-)electrochemical applications, and new and/or enhanced functions of the at least one functional element. Furthermore, the objective of the invention is to provide an improved method of manufacturing the semiconductor device, being capable of avoiding limitations of conventional manufacturing methods.

These objectives are respectively solved by a semiconductor device and a method of manufacturing thereof, the invention being defined by the independent claims. Preferred embodiments and applications of the invention are defined in the dependent claims.

According to a first general aspect of the invention, the above objective is solved by a semiconductor device comprising a substrate and at least one nano- and/or microstructure functional element (also called: 3D nano- and/or microstructure or nano- and/or microstructure semiconductor element) standing on the substrate. The substrate is a solid component with a planar extension generally defining a substrate plane. The at least one functional element is a 3D nano- and/or microstructure, which has a core region with an extension in an upward direction deviating from the substrate plane. Typically, the upward direction representing one longitudinal direction of the core region is perpendicular to the substrate plane. Preferably, the at least one functional element has a cross-sectional dimension above 5 nm and/or below 100 µm. The core region, in particular the core wall thereof, has multiple sides (lateral sides) having surface normals projecting in different directions in the substrate plane, in particular being directed in different azimuthal directions but having a common polar angle with reference to the substrate plane (or, in other words, having the same polar angle but different azimuthal angles with respect to the substrate plane as a reference plane). According to preferred examples, if the core region is straight with a core wall perpendicular to the substrate plane, like e. g. a cylinder or a hexagonal prism, the surface normals of their lateral sides have different azimuthal angles and the same polar angle equal to zero. With these preferred embodiments, the surface normals are directed in different directions parallel to the substrate plane. In dependency on the cross-sectional shape of the core region, the sides provide e. g. a cylindrical surface or a facet surface with multiple side facets. Alternatively, if the core region has a slanted core wall relative to the substrate plane, like e. g. a pyramid or cone, the surface normals of their lateral sides also have different azimuthal angles and a common polar angle unequal to zero.

According to the invention, the at least one functional element further includes multiple (at least two) active regions each being located on one of the different lateral sides of the core region and having different properties, in particular optical, optoelectronic, electronic and/or (photo-)electrochemical properties. Different optical properties comprise e. g. different refractive indices or different interactions with light (spectral response). Different optoelectronic properties comprise e. g. emission at different wavelengths in response to electrical carrier injection or different types of electrical carrier generation after interaction with light. Different electronic properties comprise e. g. different conductivities. Different (photo-)electrochemical properties comprise e. g. different adsorptivities for specific molecules and/or different detectable conductivities depending on substance adsorption. Each active region provides a specific technical function, like emission, absorption, carrier generation and/or substance adsorption, to the functional element, which can be called a multifunctional element. Thus, the at least one functional element is capable of adapting the semiconductor device for particular optical, optoelectronic, electronic and/or (photo-)electrochemical applications.

Possibly, a plurality of functional elements are provided on the substrate, wherein each of the functional elements has at least two different active regions on different lateral sides thereof. Alternatively, one single functional element with at least two different active regions can be provided on the substrate.

According to a second general aspect of the invention, the above objective is solved by a method of manufacturing the semiconductor device according to the above first general aspect of the invention, wherein at least one core region is created on the substrate, e. g. by MBE, MOCVD or chemical or thermal etching processes, and the active regions are deposited on the different lateral sides of the core region, preferably in a single growth run. Deposition on the different lateral sides is obtained by exploiting directional deposition or by selective passivation. The active regions are grown by depositing the materials of the active regions onto the respective different sides of the core region, as it is obtained (e. g. by MBE) by setting the orientation of the core region relative to the direction of the impinging material beams.

Compared with the conventionally created 3D nano- and microstructure functional elements with core-shell configuration, the present invention has the advantage of extended degrees of freedom for designing the device function. By providing different, preferably mutually separated, active regions (e. g. dots, quantum wells, layers etc.) on multiple and different individual sides, e. g. side facets, of the core region, a new 3D nano- and/or microstructure (e. g. wire, fin, pyramid, etc.) with an extended range of functions is obtained. Moreover, the individual active regions may be provided with separate electrical contacts, in order to individually control the different active regions, e.g. to individually regulate the current injection or to apply different bias voltages. In general, the invention allows to include and combine different mechanical, chemical, electronic, optical thermal, and/or magnetic functionalities in one functional element in a very compact way. Furthermore, the possibility to have different functionalities on different core wall sides with different spatial orientations facilitates new device designs with direction-dependent properties. The combination of all these beneficial factors opens up possibilities for new device architectures, functionalities and applications.

In contrast to [18] and [19], the different active regions of the inventive functional element are not arranged vertically (with respect to the substrate) on different crystal planes but on different lateral sides of the core nanostructure (which have surface normals directed in different directions parallel to the substrate plane. Hence, the invention allows to arrange several different active regions, e. g. on the vertical side facets of a nanowire, in particular with a surface area where e. g. [18] has only one type of active region. This in particular means that in contrast to the design of [18] or [19], the invention is not limited to three different active regions.

The invention allows to independently fabricate or configurate the active regions making use of e. g. a directional deposition method. Hence, the different active regions may consist of completely different materials and functionalities. Furthermore, in contrast to the design of e. g. [18], the active region area (which is crucial for many applications) for each active region of the inventive functional element may be increased by simply increasing the length of the functional element.

In contrast to the technique of [18], which needs at least two nanowires to have tunable multicolor emission, the invention advantageously allows that all different active regions of a single functional element can be contacted individually, e. g. in order to get a tunable LED device, hence, a single functional element is sufficient to have multicolor emission.

Optionally, a plurality of functional elements is provided on the substrate, wherein each of the functional elements has at least two different active regions. All functional elements on the substrate may have the same functions, or functional elements with different functions can be provided. The functional elements may have the same shape or different shapes and can be arranged with a random configuration, with a specific irregular arrangement or as a regular matrix array. The regular matrix array is preferred as manufacturing the functional elements (avoidance of mutual shadowing of neighboring core regions) and the provision of enough space for contacting the functional elements is facilitated. Furthermore, the matrix array of functional elements with light emitting and/or absorbing active regions has advantages for creating a display or a light sensor (camera) array. Specific patterns may allow the implementation of combined effects of the functional elements, e.g. acting as a photonic crystal.

According to a preferred embodiment of the invention, the active regions are mutually separated and extend in different lateral directions. With this embodiment, the active regions do not overlap, and a distance or an insulating region is provided between neighboring active regions. Advantageously, this allows the different active regions to be controlled independently, with minimal cross-talk between active regions. The insulating region comprises e. g. an electrically insulating material, e. g. a metal oxide, or a semiconductor material.

According to a further preferred embodiment of the invention, the core region comprises a semiconductor material, in particular an n-type or a p-type conductive semiconductor material, e. g. including a dopant, or an undoped semiconductor. Advantageously, employing a semiconductor core facilitates the provision of specific optical, optoelectronic, electronic or (photo-)electrochemical properties, which can be set by the core material alone or by the core material in combination with the active region materials, e. g. by providing a semiconductor heterostructure. Particularly preferred, the core region is made of GaN and each of the active regions comprises at least one (In,Ga)N quantum well, wherein the (In,Ga)N quantum wells of the active regions have different In contents. These GaN based materials advantageously emit light in the visible wavelength range. Alternatively, a GaAs bases core region with e. g. (AI,Ga,ln)As active regions can be provided, in particular for applications in the IR wavelength range.

If, according to another preferred embodiment of the invention, at least one of the active regions is covered by a capping region (or: capping material) comprising a p-type or n-type conductive material, an undoped semiconductor, a metal or an insulator, advantages for providing additional or enhanced functions of the active regions can be obtained.

Generally, the term "active region" refers to a material being arranged, e. g. deposited or grown, on or in the core wall and being different from the core material. Preferably, the active region material, optionally in combination with the core material, has a specific interaction with light and/or chemical substances. The interaction with light may comprise at least one of spectrally specific absorption, reflection and emission of light by or from the active regions. The interaction with chemical substances may comprise adsorption, e.g. adsorption of gas species.

Preferably, the active regions comprise materials with different chemical composition, thicknesses and/or crystal structures, in particular different semiconductor materials. Active regions with different thicknesses preferably are provided if the active regions are mutually separated and extend in different lateral directions. Particularly preferred, at least one of the active regions comprises at least one quantum dot, at least one quantum well, at least one layer, at least one point defect and/or at least one extended defect. Advantageously, various combinations of active regions are possible: all active regions on one common core may have the same geometry and/or structure (but different materials), or at least one of the active regions on one common core may differ from the other active regions in terms of geometry and/or structure.

According to a further preferred embodiment of the invention, at least two of the active regions of a common core region are interconnected by at least one lateral connecting region, e. g. an interconnection layer, comprising a metal, an n-type or p-type semiconductor material, an insulator or another active region, overlapping the active regions. Advantageously, this embodiment allows the provision of combined functions, in particular being determined by the degree of overlap.

Preferably, the active regions are configured for an electrical connection with at least one electrical circuit, such as a switchable power supply, a control device and/or a measurement circuit. If, according to a particularly advantageous embodiment of the invention, at least one of the active regions is individually provided with a separate electrical contact for electrically connecting the active regions with the at least one electrical circuit, advantages for the optical, optoelectronic, electronic and/or electrochemical applications of the inventive device in terms of specific control of the active regions are obtained. The electrical contacts comprise electrically conducting sections being located on the core region, a conductive substrate carrying the core region the active regions, the capping regions and/or an encapsulation material embedding the at last one functional element. The electrical contacts comprise an opaque or transparent material, like a metal or indium tin oxide (ITO), and they are isolated from each other. Alternatively or additionally, at least two of the active regions are provided with one common electrical contact being configured for electrically connecting the active regions with one electrical circuit.

Another essential advantage of the invention results from the broad variability of designing the at least one functional element, in particular the core region thereof. If according to a first geometric feature, the core region has a shape of a cone, cylinder or polyhedron (e.g. wire or column, a fin or wall, or a pyramid), advantages from adjusting a high aspect ratio can be obtained. According to further geometric features, the core region can have a straight or curved shape along the upward direction, and/or a cylindrical or conical shape, which can provide advantages for specific optical applications, e. g. to set a preferred light polarization from the active region or to make use of photonic crystal effects.

Particularly preferred dimensions of the at least one functional element comprise a cross-sectional dimension, e. g. diameter of a nanowire or thickness of a fin, of at least 15 nm and/or at most 100 µm, while a longitudinal dimension, e. g. length of a nanowire or height of a nanowall, is at least 10 nm, in particular at least 100 nm and/or at most 500 µm, in particular at most 20 µm.

According to a further particularly preferred embodiment of the invention, the active regions have different spectral features in emission and/or absorption. In particular, emission and/or absorption spectra of the active regions have emission maxima at different wavelengths (in case of emission) or different cutoff wavelengths (in case of absorption). Advantageously, this allows the provision of a broadband emitter for lighting or display applications, or a wavelength-sensitive detector, e.g. enabling multi-color micro displays or multispectral photodetectors (for IR, visible and/or UV range) with sub-micrometer pixel size and pitch.

With a preferred example, at least two, e. g. at least three different active regions are provided on the functional element, which emit and/or absorb in different spectral ranges, respectively. The emissions and/or absorption can be distributed along a spectral operation range of the inventive device, e. g. from blue via green to red wavelengths or to the IR range. Depending on the control of the individual active regions, a color of a device emission can be set. With a preferred embodiment, each of the active regions has a separate electrical contact being configured for charge carrier injection to the respective active region, wherein a light intensity emitted by the active regions can be controlled by the carrier injection. Advantageously, such a functional element could be used as a tunable Red-Green-Blue light emitter and/or tunable white light source. Alternatively, each of the active regions has a separate electrical contact for current sensing in the respective active region, wherein a wavelength and/or intensity distribution of light irradiating the semiconductor device and being absorbed by the active regions can be detected.

The invention is not restricted to purely optical, optoelectronic or electronic functionalities of the active regions. At least one of the active regions may have a sensitivity to substance adsorption, so that electrical and/or optical properties of the functional element change in dependency on substance adsorption. Thus, the functional element can be configured as an electrochemical or photo-electrochemical sensor or a photocatalytic device.

Further details and advantages of the invention are described in the following with reference to the attached drawings, which show in:
- Figure 1:: schematic illustrations of various features of semiconductor devices according to preferred embodiments of the invention;
- Figure 2:: a schematic illustration of a further embodiment of the invention;
- Figure 3:: a schematic illustration of electrically contacting a semiconductor device according to a further embodiment of the invention; and
- Figure 4:: further details of a process for electrically contacting semiconductor devices according to further embodiments of the invention.

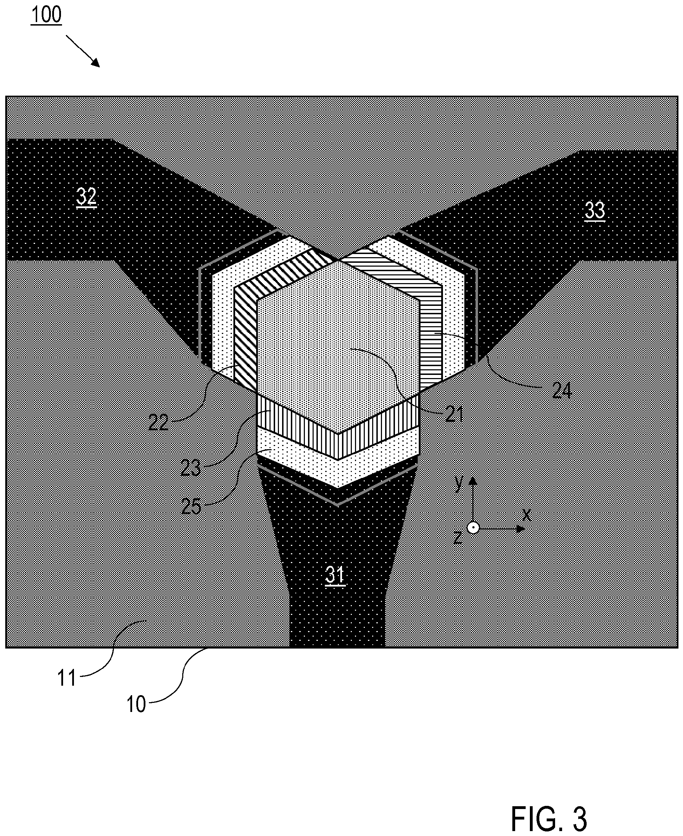

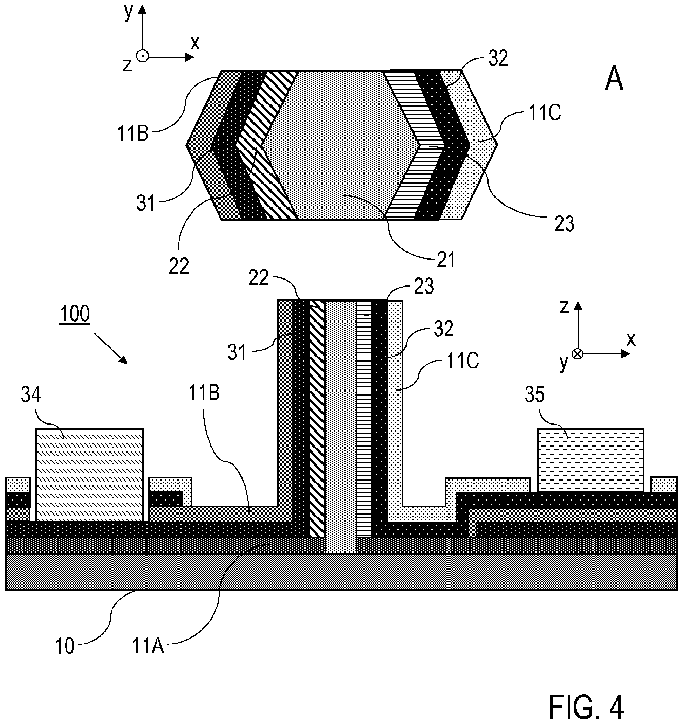

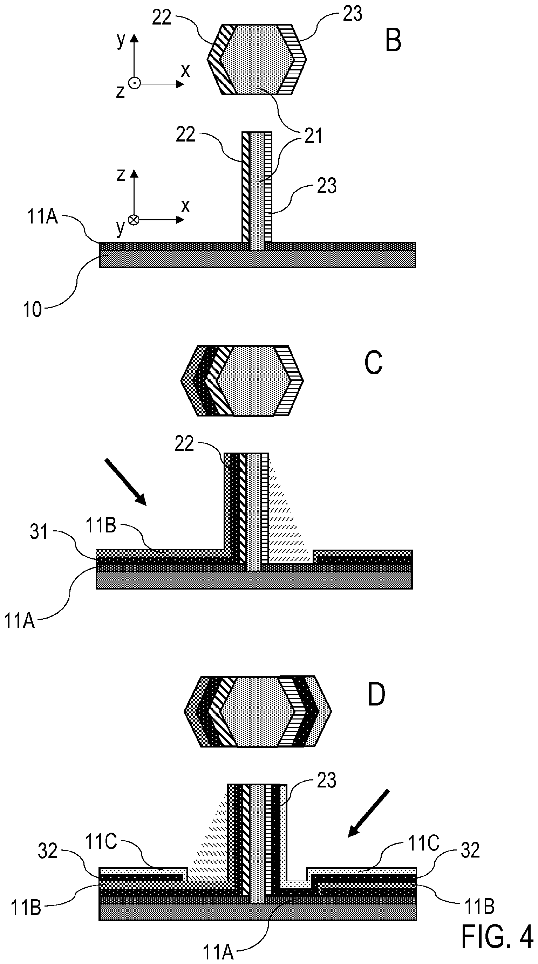

Embodiments of the invention are described in the following with reference to the configuration of active regions of an inventive semiconductor device. The described features can be provided in a device with multiple functional elements or in a single element device. The implementation of the invention is not restricted to the described embodiments and examples. In particular, while the figures show straight core regions with plane side surfaces, other types of core regions can be provided as mentioned above, like e. g. conical, cylindrical or other polyhedral core regions and/or curved core regions. For the practical application as an optoelectronic device or (photo-) electrochemical device or as an electronic circuit, the inventive semiconductor device is provided with further components, like electrical contacts on the substrate for injecting charge carriers into the functional element(s) or sensing currents created in the functional element(s) or supplying electrical signals to an electronic circuit (see Figures 3 and 4) and optionally an encapsulation layer. The encapsulation layer, e. g. made of a plastic, can be provided for embedding the functional element(s) and optionally carrying at least one electrical contact. Furthermore, the functional element(s) can be coupled with further components, like electronic circuits or optical components, like waveguides, on the substrate.

The substrate generally has a solid body (substrate body) with a surface (substrate surface), which may be a plane or a structured surface of the substrate body or a surface including or carrying at least one contact layer and/or the at least one electronic circuit and/or at least one further optical, optoelectronic, electronic or (photo-)electrochemical device. The planar extension of the substrate is represented by a reference plane parallel to the extension of the solid substrate body, e. g. the extension of the plane surface or the mean extension of the structured surface. The substrate is made of e. g. an inorganic semiconductor, a metal, a ceramic or a polymer material.

The optoelectronic device mentioned below is only one example for an inventive application of the semiconductor device design with multiple different active regions on individual lateral sides. Other applications comprise, e.g. displays, photodetectors or gas and other molecule sensors.

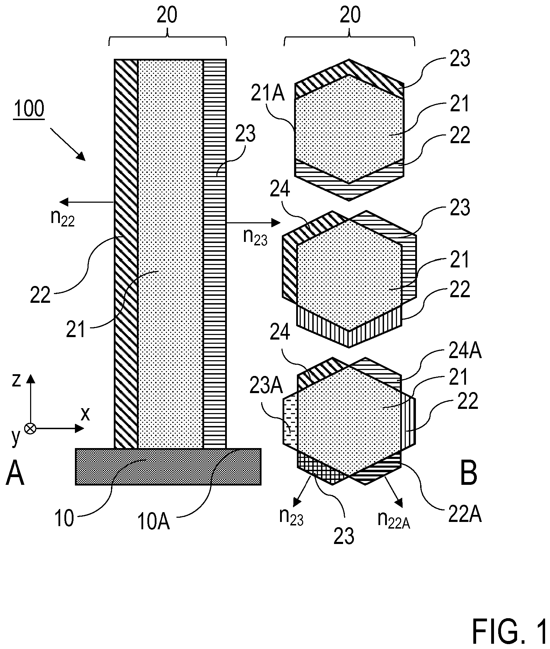

Figures 1A to 1E illustrate variants of a first embodiment of the inventive semiconductor device 100, comprising a substrate 10, made of e. g. n-type Si, and a functional element 20 with a core region 21 and multiple active regions 22, 22A, 23, 23A, 24 and 24A. The semiconductor device 100 is manufactured by a first step of fabricating the core region 21 on the substrate 10, e.g. by epitaxial growth or thermal or chemical etching, and a second step of growing the active regions 22, 22A, 23, 23A, 24 and 24A on the core region 21, e.g. by MBE or other directional deposition methods. All active regions 22, 22A, 23, 23A, 24 and 24A can be grown in a single deposition run, e. g. by step-wise rotating the substrate with the core region(s) in a deposition chamber relative to depositions sources. In particular, if the active regions comprise layers (as shown), stepwise deposition of sublayers of the active regions can be conducted, so that bending of the core region(s) is avoided.

Figure 1A shows a cross-sectional view of the substrate 10 with the functional element 20 along the upward direction (z-direction) perpendicular to the substrate plane 10A (x-y-plane). The core region 21 has e. g. a cylindrical shape, and the active regions 22 and 23 are provided on sides of the core region 21 having surface normals (see arrows n₂₂ and n₂₃) projecting in different directions in the substrate plane. In spherical coordinates with the substrate plane as reference plane, the surface normals of the sides have different azimuthal angles, but the same polar angle (zero).

Alternatively, the core region 21 is a monocrystalline semiconductor, like e. g. GaAs, with a hexagonal crystal shape and sidewall facets 21A (see e. g. cross-sectional view perpendicular to the upward direction in Figure 1B, top view). The diameter of the core region 21 is e. g. 200 nm, and the longitudinal length in vertical direction is e. g. 2 µm nm. Different active regions (in Figure 1B: two, three and six) 22, 22A, 23, 23A, 24 and 24A are provided on multiple and different individual sidewall facets 21A. These active regions may consist of different materials, structures and/or have different thicknesses, and hence have different functionalities. For example, according to Figure 1B (top view), the active regions 22 and 23 comprise layers of (In,Ga)As with different In contents, each with a thickness of e. g. 100 nm. Additionally, according to Figure 1B (middle view), a third active regions 24 can be provided, which is made of (In,Ga)(As,Sb) with a thickness of e. g. 100 nm. The variant with six active regions 22, 22A, 23, 23A, 24 and 24A (Figure 1B, bottom view) can be characterized e. g. by different materials of the active regions or by different dopants in the active regions. Again, the active regions, e. g. active regions 23 and 22A in the bottom view of Figure 1B, are provided on sides of the core region 21 having surface normals (see arrows n₂₃ and n_{22A}) projecting in different directions in the substrate plane.

According to Figure 1B, the active regions are separated from each other, e. g. as a result of the deposition process or an additional thermal or chemical etching step. On the contrary, with a further variant of the invention, by growing selectively on different facets/sides, active regions 22, 23, 24 and 24A may be interconnected (not shown).

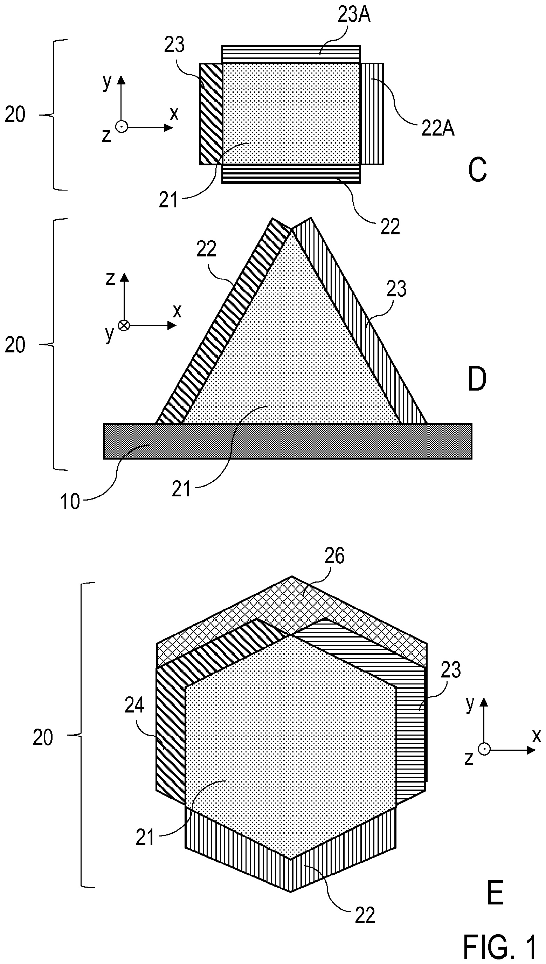

Figure 1C shows an example of a cuboid-shaped core region 21 (cross-sectional view perpendicular to the upward direction) with four side facets, each carrying a specific active region 22, 22A, 23, and 23A, while Figure 1D illustrates a pyramid-shaped core region 21, e. g. with two active regions 22, 23. With the latter embodiment, in spherical coordinates, the surface normals of the sides have different azimuthal angles again, but the same polar angle unequal to zero.

Figure 1E shows that two of the active regions 23, 24, e. g in an embodiment of Figure 1B (middle view), may be interconnected by a connecting region 26, comprising e. g. an electrically conductive interconnection layer.

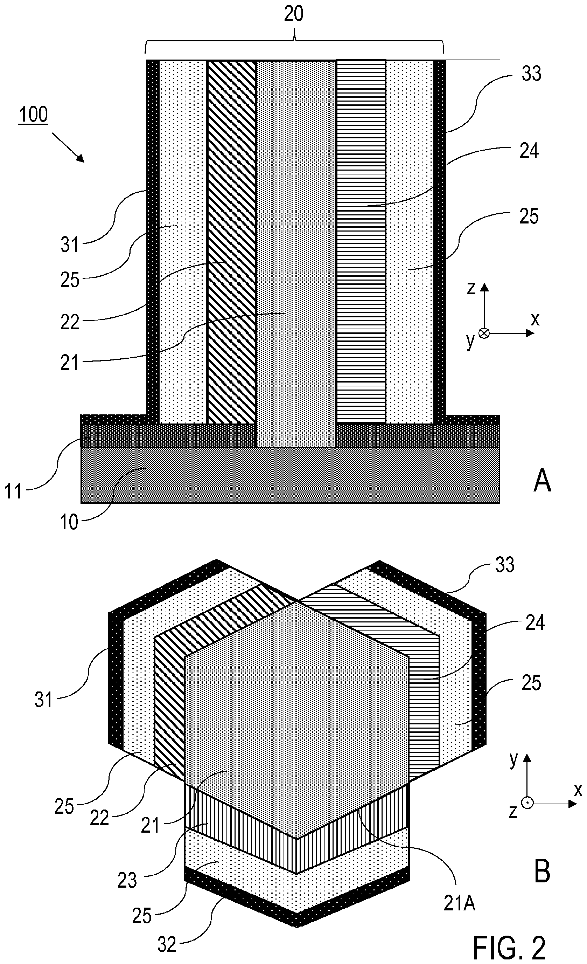

Figures 2 and 3 show an optoelectronic semiconductor device 100 based on a single semiconductor functional element 20 with cross-sectional side (Figure 2A) and top (Figure 2B) views and a top view including the substrate 10 (Figure 3). The semiconductor functional element 20 is a nanowire, where different lateral light-emitting (or light-detecting) active regions 22, 23 and 24 are individually contacted and therefore independently tunable (or detectable).

The semiconductor device 100 of Figure 2 comprises an electrically conductive substrate 10, being made of e. g. n-type Si and carrying the core region 21. An insulating mask 11, being made of e. g. SiO₂ with a thickness of 10 nm surrounds the core region 21. Each side facet 21A of the core region 21 carries a sequence of active regions 22 (or:23, 24) and capping layers 25 on each of the active regions 22, 23 and 24. The core region 21 is made of n-type GaN with a diameter of e. g. 200 nm and a longitudinal length of e. g. 1 µm. The active regions 22, 23, 24 may comprise thick layers, e. g. (In,Ga)N, quantum wells, quantum wires, quantum dots, e. g. (In,Ga)N, extended defects or point defects, e. g. rare earth dopants, and they are capped individually by the capping layers 25, e. g. made of p-type GaN with a thickness of 50 nm. Separate electrical contacts 31, 32 and 33 are located on the capping layers 25 and continued on the substrate 10 (see Figure 3). The contacts 31, 32 and 33 comprise same or different materials, e. g. ITO or metal, like Ni/Au having a thickness of e .g. 30 nm or 10 nm, respectively.

The semiconductor device 100 of Figure 2 may be used e. g. for a tunable nanoscale multicolor light-emitting diode (LED) based on a single or on multiple semiconductor nanowires. Such an LED architecture, e.g. may provide Red-Green-Blue screen (display) pixels. In order to achieve luminescence at the different colors, e.g. red, green, blue, the directional character of MBE can be used to grow (In,Ga)N quantum wells (QWs) with different In contents on different side facets 21A. The advantages in comparison to previous approaches [1, 13-16] are the sub-micrometer device size, the possibility to individually contact the different lateral heterostructures and the ability to realize a compact arrangement of multiple emitters in one semiconductor device. Apart from a light-emitting device, a similar structure may also be used as a wavelength-discriminating photodetector or a multi-band absorber for photovoltaic applications.

Figure 4 shows further details of contacting the active regions 22, 23 with another embodiment of the invention (similar to the embodiment of Figure 1B, top view). The semiconductor device 100 (Figure 4A) has the core region 21 with a sequence of an active region 22/23, a conductive layer 31/32 and an insulating mask 11B/11C on different sides being arranged on a conductive substrate 10 (the active regions may be capped by further capping regions, which are not shown).

The process of manufacturing the semiconductor device 100 is further shown in Figures 4B to 4D. Firstly, the core region 21 with the active regions 22, 23 is created (Figure 4B). The substrate 10 contacts the core region 21. A first insulating mask 11A covers the substrate 10. Subsequently, a first electrically conducting layer 31 is deposited from one side (see arrow in Figure 4C), contacting the active region 22 and covering the first insulating mask 11A. A second insulating mask 11B is deposited from the same side covering the first electrically conducting layer 31. Due to shadowing, the insulating mask 11A is only partially covered by layers 31 and 11B. Subsequently, a second electrically conducting layer 32 is deposited form a different side (see arrow in Figure 4D), contacting the active region 23 and covering the second insulating mask 11B as well as parts of the first insulating mask 11A (parts which were shadowed before). A third insulating mask 11C is deposited from the same side covering the second electrically conducting layer 32. Due to shadowing, the insulating mask 11B is only partially covered by layers 32 and 11C. The insulating mask 11C, the second conductive layer 32 and the insulating mask 11B are partially etched, providing a space for a contact pad 34 (or a contacting layer) as shown in Figure 4A, allowing an access to the first active region 22. By the partial etching it is possible to keep the contact pad 34 insulated from second conductive layer 32, while an interruption of the second conductive layer 32 is avoided. Furthermore, the insulating mask 11C is partially etched, providing a space for a further contact pad 35 allowing an access to the second active region 23 (see Figure 4A).

The features of the invention disclosed in the above description, the drawings and the claims can be of significance individually, in combination or sub-combination for the implementation of the invention in its different embodiments.

## Claims

1. Semiconductor device (100), in particular being configured for optical, optoelectronic, electronic and/or (photo-)electrochemical applications, comprising
- a substrate (10) and at least one nano- or microstructure functional element (20) standing on the substrate (10) and having a core region (21) extending in an upward direction deviating from a substrate plane,
**characterized in that**
- the at least one functional element (20) further includes multiple different active regions (22, 22A, 23, 23A, 24 and 24A) being located on different lateral sides of the core region (21) having surface normals being directed in different azimuthal directions but having a common polar angle with reference to the substrate plane, wherein the active regions (22, 22A, 23, 23A, 24 and 24A) have different optical, optoelectronic, electronic and/or or (photo-)electrochemical properties.

2. Semiconductor device according to claim 1, wherein
- the multiple different active regions (22, 22A, 23, 23A, 24 and 24A) are located on the different lateral sides of the core region (21) having surface normals being directed in different directions parallel to the substrate plane.

3. Semiconductor device according to one of the foregoing claims, wherein
- the core region (21) has a cylindrical surface or a facet surface with multiple side facets, and
- the multiple active regions (22, 22A, 23, 23A, 24 and 24A) are located on different lateral sides of the cylindrical surface or different side facets of the facet surface.

4. Semiconductor device according to one of the foregoing claims, comprising at least one of the features
- the active regions (22, 22A, 23, 23A, 24 and 24A) comprise materials with different chemical composition and/or crystal structure, and
- the active regions (22, 22A, 23, 23A, 24 and 24A) are mutually separated and extend in different lateral directions.

5. Semiconductor device according to claim 4, wherein
- the active regions (22, 22A, 23, 23A, 24 and 24A) are mutually separated and extend in different lateral directions, and
- the active regions (22, 22A, 23, 23A, 24 and 24A) comprise materials with different thicknesses.

6. Semiconductor device according to one of the foregoing claims, comprising at least one of the features
- the core region (21) comprises an n-type, a p-type or an undoped semiconductor,
- at least one of the active regions (22, 22A, 23, 23A, 24 and 24A) is capped by a capping region (25) comprising an n-type, p-type or an undoped semiconductor, a metal or an insulator,
- at least one of the active regions (22, 22A, 23, 23A, 24 and 24A) comprises at least one quantum dot, at least one quantum well, at least one layer, at least one point defect and/or at least one extended defect.

7. Semiconductor device according to one of the foregoing claims, wherein
- the core region (21) is made of GaN, and
- each of the active regions (22, 22A, 23, 23A, 24 and 24A) comprises at least one (In,Ga)N quantum well, wherein the (In,Ga)N quantum wells of the active regions (22, 22A, 23, 23A, 24 and 24A) have different In contents and/or thicknesses.

8. Semiconductor device according to one of the foregoing claims, comprising at least one of the features
- at least two of the active regions (22, 22A, 23, 23A, 24 and 24A) are interconnected by at least one lateral connecting region (26) overlapping the active regions (23, 24), and
- at least one of the active regions (22, 22A, 23, 23A, 24 and 24A) is individually provided with separate electrical contacts (31, 32, 33) being configured for electrically connecting the active regions (22, 22A, 23, 23A, 24 and 24A) with at least one electrical circuit,
- the active regions (22, 22A, 23, 23A, 24 and 24A) are configured for at least one of light emission and absorption at different wavelengths, and
- at least one of the active regions (22, 22A, 23, 23A, 24 and 24A) has a sensitivity to substance adsorption, so that electrical and/or optical properties of the functional element (20) change in dependency on substance adsorption.

9. Semiconductor device according to one of the claims 1 to 7, wherein
- at least two of the active regions (22, 22A, 23, 23A, 24 and 24A) are provided with one common electrical contact being configured for electrically connecting the active regions (22, 22A, 23, 23A, 24 and 24A) with an electrical circuit.

10. Semiconductor device according to one of the foregoing claims, wherein the at least one functional element (20) has at least one of the following features:
- the core region (21) has a shape of a cone, cylinder or polyhedron, in particular a wire, a fin, or a pyramid,
- the core region (21) has a straight shape,
- the core region (21) has a curved shape,
- the at least one functional element (20) has a cross-sectional dimension perpendicular to the upward direction of at least 15 nm,
- the at least one functional element (20) has a cross-sectional dimension perpendicular to the upward direction of at most 100 µm,
- the at least one functional element (20) has a longitudinal dimension along the upward direction of at least 10 nm, in particular at least 100 nm,
- the at least one functional element (20) has a longitudinal dimension along the upward direction at most 500 µm, in particular at most 20 µm.

11. Semiconductor device according to one of the foregoing claims, wherein
- at least two different active regions (22, 22A, 23, 23A, 24 and 24A) are provided which emit and/or absorb in different spectral ranges, respectively.

12. Semiconductor device according to claim 11, wherein
- each of the active regions (22, 22A, 23, 23A, 24 and 24A) has a separate electrical contact (31, 32, 33) being configured for carrier injection to the respective active region (22, 22A, 23, 23A, 24 and 24A), wherein a light intensity emitted by the active regions (22, 22A, 23, 23A, 24 and 24A) can be controlled by the carrier injection, or
- each of the active regions (22, 22A, 23, 23A, 24 and 24A) has a separate electrical contact (31, 32, 33) being configured for current sensing in the respective active region (22, 22A, 23, 23A, 24 and 24A), wherein a wavelength characteristic of light absorbed by the active regions (22, 22A, 23, 23A, 24 and 24A) can be detected.

13. Semiconductor device according to one of the foregoing claims, wherein
- a plurality of functional elements (20) stand on the substrate (10), and
- each of the functional elements (20) has the at least two active regions (22, 22A, 23, 23A, 24 and 24A).

14. Method of manufacturing the semiconductor device (100) according to one of the foregoing claims, comprising the steps of
- creating at least one core region (21) on the substrate (10), and
- depositing the different active regions (22, 22A, 23, 23A, 24 and 24A) on the lateral sides of the core region (21).

15. Method according to claim 14, wherein
- the step of depositing the active regions (22, 22A, 23, 23A, 24 and 24A) on the different lateral sides employs directional deposition or selective passivation.

## Patentansprüche

1. Halbleitervorrichtung (100), die insbesondere für optische, optoelektronische, elektronische und/oder (photo-)elektrochemische Anwendungen konfiguriert ist, umfassend
- ein Substrat (10) und zumindest ein auf dem Substrat (10) stehendes Nano- oder Mikrostruktur-Funktionselement (20) mit einem sich in einer von einer Substratebene abweichenden Aufwärtsrichtung erstreckenden Kernbereich (21),
**dadurch gekennzeichnet, dass**
- das zumindest eine Funktionselement (20) des Weiteren mehrere unterschiedliche aktive Bereiche (22, 22A, 23, 23A, 24 und 24A) aufweist, die sich auf unterschiedlichen lateralen Seiten des Kernbereichs (21) befinden, die Oberflächennormalen aufweisen, die in unterschiedliche azimutale Richtungen gerichtet sind, aber einen gemeinsamen Polarwinkel in Bezug auf die Substratebene haben, wobei die aktiven Bereiche (22, 22A, 23, 23A, 24 und 24A) unterschiedliche optische, optoelektronische, elektronische und/oder (photo-)elektrochemische Eigenschaften aufweisen.

2. Halbleitervorrichtung gemäß Anspruch 1, wobei
- die mehreren unterschiedlichen aktiven Bereiche (22, 22A, 23, 23A, 24 und 24A) auf den unterschiedlichen lateralen Seiten des Kernbereichs (21) angeordnet sind, die Oberflächennormalen aufweisen, die in unterschiedliche Richtungen parallel zur Substratebene gerichtet sind.

3. Halbleitervorrichtung gemäß einem der vorhergehenden Ansprüche, wobei
- der Kernbereich (21) eine zylindrische Oberfläche oder eine Facettenoberfläche mit mehreren Seitenfacetten aufweist, und
- die mehreren aktiven Bereiche (22, 22A, 23, 23A, 24 und 24A) auf verschiedenen lateralen Seiten der zylindrischen Oberfläche oder verschiedenen Seitenfacetten der Facettenoberfläche angeordnet sind.

4. Halbleitervorrichtung gemäß einem der vorhergehenden Ansprüche, umfassend zumindest eines der Merkmale
- die aktiven Bereiche (22, 22A, 23, 23A, 24 und 24A) umfassen Materialien mit unterschiedlicher chemischer Zusammensetzung und/oder Kristallstruktur, und
- die aktiven Bereiche (22, 22A, 23, 23A, 24 und 24A) sind voneinander getrennt und erstrecken sich in unterschiedliche laterale Richtungen.

5. Halbleitervorrichtung gemäß Anspruch 4, wobei
- die aktiven Bereiche (22, 22A, 23, 23A, 24 und 24A) voneinander getrennt sind und sich in unterschiedliche laterale Richtungen erstrecken, und
- die aktiven Bereiche (22, 22A, 23, 23A, 24 und 24A) Materialien mit unterschiedlichen Dicken umfassen.

6. Halbleitervorrichtung gemäß einem der vorhergehenden Ansprüche, umfassend zumindest eines der Merkmale
- der Kernbereich (21) umfasst einen n-Typ, einen p-Typ oder einen undotierten Halbleiter,
- zumindest einer der aktiven Bereiche (22, 22A, 23, 23A, 24 und 24A) ist durch ein Abdeckbereich (25) abgedeckt, der einen n-Typ, p-Typ oder einen undotierten Halbleiter, ein Metall oder einen Isolator umfasst,
- zumindest einer der aktiven Bereiche (22, 22A, 23, 23A, 24 und 24A) umfasst zumindest einen Quantenpunkt, zumindest einen Quantentopf, zumindest eine Schicht, zumindest einen Punktdefekt und/oder zumindest einen ausgedehnten Defekt.

7. Halbleitervorrichtung gemäß einem der vorhergehenden Ansprüche, wobei
- der Kernbereich (21) aus GaN hergestellt ist, und
- jeder der aktiven Bereiche (22, 22A, 23, 23A, 24 und 24A) zumindest einen (In,Ga)N-Quantentopf umfasst, wobei die (In,Ga)N-Quantentöpfe der aktiven Bereiche (22, 22A, 23, 23A, 24 und 24A) unterschiedliche In-Gehalte und/oder Dicken aufweisen.

8. Halbleitervorrichtung gemäß einem der vorhergehenden Ansprüche, umfassend zumindest eines der Merkmale
- zumindest zwei der aktiven Bereiche (22, 22A, 23, 23A, 24 und 24A) sind durch zumindest einen lateralen Verbindungsbereich (26) miteinander verbunden, der die aktiven Bereiche (23, 24) überlappt, und
- zumindest einer der aktiven Bereiche (22, 22A, 23, 23A, 24 und 24A) ist individuell mit separaten elektrischen Kontakten (31, 32, 33) versehen, die zum elektrischen Verbinden der aktiven Bereiche (22, 22A, 23, 23A, 24 und 24A) mit zumindest einem elektrischen Stromkreis ausgebildet sind,
- die aktiven Bereiche (22, 22A, 23, 23A, 24 und 24A) sind für zumindest eine von Lichtemission und
- absorption bei unterschiedlichen Wellenlängen konfiguriert, und
- zumindest einer der aktiven Bereiche (22, 22A, 23, 23A, 24 und 24A) weist eine Sensitivität gegenüber Substanzadsorption auf, so dass sich elektrische und/oder optische Eigenschaften des Funktionselements (20) in Abhängigkeit von der Substanzadsorption ändern.

9. Halbleitervorrichtung gemäß einem der Ansprüche 1 bis 7, wobei
- zumindest zwei der aktiven Bereiche (22, 22A, 23, 23A, 24 und 24A) mit einem gemeinsamen elektrischen Kontakt versehen sind, der zur elektrischen Verbindung der aktiven Bereiche (22, 22A, 23, 23A, 24 und 24A) mit einem elektrischen Stromkreis ausgebildet ist.

10. Halbleitervorrichtung gemäß einem der vorhergehenden Ansprüche, wobei das zumindest eine Funktionselement (20) zumindest eines der folgenden Merkmale aufweist:
- der Kernbereich (21) hat die Form eines Kegels, Zylinders oder Polyeders, insbesondere eines Drahtes, einer Rippe oder einer Pyramide,
- der Kernbereich (21) hat eine gerade Form,
- der Kernbereich (21) hat eine gekrümmte Form,
- das zumindest eine Funktionselement (20) hat eine Querschnittsabmessung senkrecht zur Aufwärtsrichtung von zumindest 15 nm,
- das zumindest eine Funktionselement (20) hat eine Querschnittsabmessung senkrecht zur Aufwärtsrichtung von höchstens 100 µm,
- das zumindest eine Funktionselement (20) hat eine Längsabmessung entlang der Aufwärtsrichtung von zumindest 10 nm, insbesondere von zumindest 100 nm,
- das zumindest eine Funktionselement (20) hat eine Längsabmessung entlang der Aufwärtsrichtung von höchstens 500 µm, insbesondere von höchstens 20 µm.

11. Halbleitervorrichtung gemäß einem der vorhergehenden Ansprüche, wobei
- zumindest zwei unterschiedliche aktive Bereiche (22, 22A, 23, 23A, 24 und 24A) vorgesehen sind, die in unterschiedlichen Spektralbereichen emittieren und/oder absorbieren.

12. Halbleitervorrichtung gemäß Anspruch 11, wobei
- jeder der aktiven Bereiche (22, 22A, 23, 23A, 24 und 24A) einen separaten elektrischen Kontakt (31, 32, 33) aufweist, der zur Ladungsträgerinjektion in den jeweiligen aktiven Bereich (22, 22A, 23, 23A, 24 und 24A) ausgebildet ist, wobei eine von den aktiven Bereichen (22, 22A, 23, 23A, 24 und 24A) emittierte Lichtintensität durch die Ladungsträgerinjektion steuerbar ist, oder
- jeder der aktiven Bereiche (22, 22A, 23, 23A, 24 und 24A) einen separaten elektrischen Kontakt (31, 32, 33) aufweist, der zur Stromerfassung im jeweiligen aktiven Bereich (22, 22A, 23, 23A, 24 und 24A) ausgebildet ist, wobei eine Wellenlängencharakteristik des von den aktiven Bereichen (22, 22A, 23, 23A, 24 und 24A) absorbierten Lichts detektierbar ist.

13. Halbleitervorrichtung gemäß einem der vorhergehenden Ansprüche, wobei
- eine Mehrzahl von Funktionselementen (20) auf dem Substrat (10) stehen, und
- jedes der Funktionselemente (20) die zumindest zwei aktiven Bereiche (22, 22A, 23, 23A, 24 und 24A) aufweist.

14. Verfahren zur Herstellung der Halbleitervorrichtung (100) gemäß einem der vorhergehenden Ansprüche, umfassend die Schritte
- Erzeugen zumindest eines Kernbereichs (21) auf dem Substrat (10), und
- Deponieren der verschiedenen aktiven Bereiche (22, 22A, 23, 23A, 24 und 24A) an den lateralen Seiten des Kernbereichs (21).

15. Verfahren gemäß Anspruch 14, wobei
- der Schritt des Deponierens der aktiven Bereiche (22, 22A, 23, 23A, 24 und 24A) auf den verschiedenen lateralen Seiten ein gerichtetes Deponieren oder eine selektive Passivierung verwendet.

## Revendications

1. Dispositif à semi-conducteur (100), en particulier étant configuré pour des applications optiques, optoélectroniques, électroniques et/ou (photo-)électrochimiques, comprenant
- un substrat (10) et au moins un élément fonctionnel de nano- ou microstructure (20) se dressant sur le substrat (10) et présentant une région centrale (21) s'étendant dans une direction vers le haut s'écartant d'un plan de substrat,
**caractérisé en ce que**
- l'au moins un élément fonctionnel (20) comprend en outre de multiples différentes régions actives (22, 22A, 23, 23A, 24 et 24A) étant situées sur différents côtés latéraux de la région centrale (21) présentant des normales de surface étant dirigées dans des directions azimutales différentes mais présentant un angle polaire commun en référence au plan de substrat, dans lequel les régions actives (22, 22A, 23, 23A, 24 et 24A) présentent des propriétés optiques, optoélectroniques, électroniques et/ou (photo-)électrochimiques différentes.

2. Dispositif à semi-conducteur selon la revendication 1, dans lequel
- les multiples différentes régions actives (22, 22A, 23, 23A, 24 et 24A) sont situées sur les différents côtés latéraux de la région centrale (21) présentant des normales de surface étant dirigées dans différentes directions parallèles au plan de substrat.

3. Dispositif à semi-conducteur selon l'une des revendications précédentes, dans lequel
- la région centrale (21) présente une surface cylindrique ou une surface à facettes ayant de multiples facettes latérales, et
- les multiples régions actives (22, 22A, 23, 23A, 24 et 24A) sont situées sur différents côtés latéraux de la surface cylindrique ou différentes facettes latérales de la surface à facettes.

4. Dispositif à semi-conducteur selon l'une des revendications précédentes, comprenant au moins l'une des caractéristiques
- les régions actives (22, 22A, 23, 23A, 24 et 24A) comprennent des matériaux ayant une composition chimique et/ou une structure cristalline différente, et
- les régions actives (22, 22A, 23, 23A, 24 et 24A) sont mutuellement séparées et s'étendent dans différentes directions latérales.

5. Dispositif à semi-conducteur selon la revendication 4, dans lequel
- les régions actives (22, 22A, 23, 23A, 24 et 24A) sont mutuellement séparées et s'étendent dans différentes directions latérales, et
- les régions actives (22, 22A, 23, 23A, 24 et 24A) comprennent des matériaux ayant différentes épaisseurs.

6. Dispositif à semi-conducteur selon l'une des revendications précédentes, comprenant au moins l'une des caractéristiques
- la région centrale (21) comprend un semi-conducteur de type n, de type p ou non dopé,
- au moins l'une des régions actives (22, 22A, 23, 23A, 24 et 24A) est coiffée par une région de coiffage (25) comprenant un semi-conducteur de type n, de type p ou non dopé, un métal ou un isolant,
- au moins l'une des régions actives (22, 22A, 23, 23A, 24 et 24A) comprend au moins une boîte quantique, au moins un puits quantique, au moins une couche, au moins un défaut ponctuel et/ou au moins un défaut étendu.

7. Dispositif à semi-conducteur selon l'une des revendications précédentes, dans lequel
- la région centrale (21) est faite de GaN, et
- chacune des régions actives (22, 22A, 23, 23A, 24 et 24A) comprend au moins un puits quantique (In,Ga)N, dans lequel les puits quantiques (In,Ga)N des régions actives (22, 22A, 23, 23A, 24 et 24A) présentent différent teneurs en In et/ou épaisseurs.

8. Dispositif à semi-conducteur selon l'une des revendications précédentes, comprenant au moins l'une des caractéristiques
- au moins deux des régions actives (22, 22A, 23, 23A, 24 et 24A) sont interconnectées par au moins une région de connexion latérale (26) chevauchant les régions actives (23, 24), et
- au moins l'une des régions actives (22, 22A, 23, 23A, 24 et 24A) est individuellement dotée de contacts électriques (31, 32, 33) séparés étant configurés pour connecter électriquement les régions actives (22, 22A, 23, 23A, 24 et 24A) à au moins un circuit électrique,
- les régions actives (22, 22A, 23, 23A, 24 et 24A) sont configurées pour au moins l'une d'une émission et d'une absorption de lumière à différentes longueurs d'onde, et
- au moins l'une des régions actives (22, 22A, 23, 23A, 24 et 24A) présente une sensibilité à l'adsorption de substances, de sorte que les propriétés électriques et/ou optiques de l'élément fonctionnel (20) changent en fonction de l'adsorption de substances.

9. Dispositif à semi-conducteur selon l'une des revendications 1 à 7, dans lequel
- au moins deux des régions actives (22, 22A, 23, 23A, 24 et 24A) sont dotées d'un contact électrique commun étant configuré pour connecter électriquement les régions actives (22, 22A, 23, 23A, 24 et 24A) à un circuit électrique.

10. Dispositif à semi-conducteur selon l'une des revendications précédentes, dans lequel l'au moins un élément fonctionnel (20) présente au moins l'une des caractéristiques suivantes :
- la région centrale (21) présente une forme d'un cône, d'un cylindre ou d'un polyèdre, en particulier d'un fil, d'une ailette ou d'une pyramide,
- la région centrale (21) présente une forme droite,
- la région centrale (21) présente une forme incurvée,
- l'au moins un élément fonctionnel (20) présente une dimension de section transversale perpendiculaire à la direction vers le haut d'au moins 15 nm,
- l'au moins un élément fonctionnel (20) présente une dimension de section transversale perpendiculaire à la direction vers le haut d'au plus 100 µm,
- l'au moins un élément fonctionnel (20) présente une dimension longitudinale le long de la direction vers le haut d'au moins 10 nm, en particulier d'au moins 100 nm,
- l'au moins un élément fonctionnel (20) présente une dimension longitudinale le long de la direction vers le haut d'au plus 500 µm, en particulier d'au plus 20 µm.

11. Dispositif à semi-conducteur selon l'une des revendications précédentes, dans lequel
- au moins deux différentes régions actives (22, 22A, 23, 23A, 24 et 24A) sont fournies qui émettent et/ou absorbent dans différentes plages spectrales, respectivement.

12. Dispositif à semi-conducteur selon la revendication 11, dans lequel
- chacune des régions actives (22, 22A, 23, 23A, 24 et 24A) présente un contact électrique (31, 32, 33) séparé étant configuré une injection de porteur dans la région active (22, 22A, 23, 23A, 24 et 24A) respective, dans lequel une intensité de lumière émise par les régions actives (22, 22A, 23, 23A, 24 et 24A) peut être commandée par l'injection de porteur, ou
- chacune des régions actives (22, 22A, 23, 23A, 24 et 24A) présente un contact électrique (31, 32, 33) séparé étant configuré pour une détection de courant dans la région active (22, 22A, 23, 23A, 24 et 24A) respective, dans lequel une caractéristique de longueur d'onde de la lumière absorbée par les régions actives (22, 22A, 23, 23A, 24 et 24A) peut être détectée.

13. Dispositif à semi-conducteur selon l'une des revendications précédentes, dans lequel
- une pluralité d'éléments fonctionnels (20) se dresse sur le substrat (10), et
- chacun des éléments fonctionnels (20) présente les au moins deux régions actives (22, 22A, 23, 23A, 24 et 24A).

14. Procédé de fabrication du dispositif à semi-conducteur (100) selon l'une des revendications précédentes, comprenant les étapes de
- création d'au moins une région centrale (21) sur le substrat (10), et
- dépôt des différentes régions actives (22, 22A, 23, 23A, 24 et 24A) sur les côtés latéraux de la région centrale (21).

15. Procédé selon la revendication 14, dans lequel
- l'étape de dépôt des régions actives (22, 22A, 23, 23A, 24 et 24A) sur les différents côtés latéraux emploie un dépôt directionnel ou une passivation sélective.
